# EUROPÄISCHE PATENTSCHRIFT

(11) **EP 1 060 513 B1**
(45) Veröffentlichungstag und Bekanntmachung des Hinweises auf die Patenterteilung: **19.08.2009**
(21) Anmeldenummer: 99913085.9
(22) Anmeldetag: 24.02.1999
(51) Int. Cl.: H01L 25/10

(54) **HALBLEITERBAUELEMENT MIT MEHREREN HALBLEITERCHIPS**
SEMICONDUCTOR COMPONENT WITH SEVERAL SEMICONDUCTOR CHIPS
COMPOSANT SEMI-CONDUCTEUR COMPRENANT PLUSIEURS PUCES SEMI-CONDUCTRICES

(30) Priorität: 03.03.1998 DE 19808986
(43) Veröffentlichungstag der Anmeldung: 20.12.2000
(73) Patentinhaber: Infineon Technologies AG, 81669 München (DE)
(72) Erfinder: TUTSCH, Günter, D-93342 Saal (DE); MÜNCH, Thomas, D-93164 Laaber (DE)
(74) Vertreter: Epping - Hermann - Fischer
(86) Internationale Anmeldenummer: PCT/DE1999/000496
(87) Internationale Veröffentlichungsnummer: WO 1999/045592

(56) Entgegenhaltungen:
- EP-A- 0 575 806
- WO-A-88/05251
- WO-A-95/11523
- WO-A-96/31100
- WO-A-99/36962
- DE-A- 3 838 085
- US-A- 5 434 745
- MINEHAN W T ET AL: "FABRICATION, ASSEMBLY, AND CHARACTERIZATION OF STACKED MULTICHIP MODULES USING HOT PRESSED, CO-FIRED ALUMINUM NITRIDE" INTERNATIONAL JOURNAL OF MICROCIRCUITS AND ELECTRONIC PACKAGING, Bd. 17, Nr. 4, 1. Oktober 1994, Seiten 369-375, XP000497399

## Beschreibung

Die Erfindung betrifft ein modulweise erweiterbares Halbleiterbauelement mit mindestens einer Trägerlage, zwei Zwischenlagen und zwei Decklagen, wobei auf der Trägerlage beidseitig zumindest ein Halbleiterchip aufgebracht ist.

Oberflächenmontierte elektronische Bauelemente, auch SMD-Bauelemente genannt, werden üblicherweise in ein Gehäuse aus einer Kunststoffpressmasse eingebettet, aus dem elektrische Anschlüsse herausgeführt werden. Es existiert eine Vielzahl von unterschiedlichen Gehäusebauformen, die verschieden groß sind und eine unterschiedliche Anzahl an Anschlüssen aufweisen. Ein Halbleiterchip wird dabei zunächst mit einem Trägerlage verbunden. Die Verbindung des Halbleiterchips mit dem Trägerlage erfolgt üblicherweise durch eine Klebung, durch Lötung oder durch eine Legierung. Nach dem befestigen des Halbleiterchips werden dessen einzelne Anschlußpunkte mit den Anschlüssen des Trägerrahmens, zum Beispiel mit Bonddrähten verbunden. Danach werden der Halbleiterchip und die Anschlüsse des Anschlußrahmens so umspritzt, daß der Halbleiterchip vollständig gekapselt ist und die Anschlüsse aus dem Gehäuse herausragen.

Es besteht die Notwendigkeit, das Halbleiterbauelement mit möglichst geringen Abmessungen zu gestalten. Bei möglichst geringem Volumen soll eine möglichst hohe Speicherdichte bzw. Performance des Halbleiterbauelements realisiert werden. Will man den Gehäuseplatzbedarf verringern, so geht dies bei peripherer Außenanschlußanordnung nur durch eine deutliche Verfeinerung des Anschlußrasters. Mit dieser Miniaturisierung der Außenanschlußordnung gerät man jedoch immer mehr an die Grenzen der Prozeßfähigkeit, sowohl bei der Fertigung als auch beim Einlöten auf den Baugruppenträger. Dies bedingt vollkommen neue Technologien der Bauform, beispielsweise das Multichipmodul (MCM).

In einem herkömmlichen Multichipmodul werden mehrere Halbleiterchips in einer Ebene nebeneinander auf ein Substrat aufgebracht und mit diesem verbunden. Es besteht dabei die Möglichkeit, interne Chip zu Chip Verbindungen zu realisieren. Neben den Plastic-Leadframe-Packages, bei denen die Halbleiterchips auf eine Substratlage aufgebracht werden und die nach dem elektrischen Kontaktieren von einer umgehenden Kunststoffspritzmasse umgeben werden, existieren auch Keramik-Packages mit einer Kavität, in die die Halbleiterchips eingebracht werden. Man unterscheidet 3 Konstruktionsprinzipien:
In einer ersten Ausführungsform wird ein Mehrlagenverdrahtungssystem (Substrat) in ein Gehäuse integriert. Dieses Prinzip findet vor allem bei den Plastic-Leadframe-Packages Anwendung. In einer zweiten Herstellungsform weist das Gehäuse bereits ein Verdrahtungsträgersystem auf (Cofire-Keramik-und Laminat-Packages). In einer dritten und der einfachsten Form weist das Gehäuse eine Konstruktion ohne Verdrahtungsträgersystem auf. Es bietet sich hierbei die Möglichkeit für einfache Multichipmodule mit zwei oder maximal 3 Halbleiterchips eine direkte Verbindung über eine Drahtverbindung untereinander herzustellen.

Neben der komplizierten Herstellung des sogenannten Substrats besteht der Hauptnachteil der herkömmlichen Multichipmodule darin, daß diese nicht für eine wirtschaftliche Massenproduktion geeignet sind.

Aus der WO 99/36962 ist eine Anordnung bekannt, wobei mehrere Halbleiterchips in einem Gehäuse untergebracht sind. Dabei werden mehrere Substratlagen einseitig mit Halbleiterchips bestückt und übereinander platziert. Die Halbleiterchips können mittels aufgebrachten Leiterbahnen untereinander sowie mit Außenkontakten der Anordnung verbunden werden.

Die Aufgabe der Erfindung besteht deshalb darin, ein Halbleiterbauelement zu entwickeln, bei dem durch eine beidseitig bestückbare Substratlage ein geringer Volumenverbrauch sowie eine hohe Packungsdichte erzielt werden. Ferner soll eine hohe Zuverlässigkeit bei gleichzeitig geringen Fertigungskosten gewährleistet sein.

Diese Aufgabe wird gemäß den Merkmalen des Patentanspruchs 1 gelöst.

Weiterbildungen der Erfindung sind Gegenstand der Unteransprüche.

Der Grundgedanke der Erfindung besteht darin, mehrere Halbleiterchips in einem Halbleiterbauelement unterzubringen, wobei die Halbleiterchips nicht nur auf einer einseitig bestückbaren Substratebene angeordnet sind, sondern die Substratlage beidseitig bestückbar ist und darüber hinaus diese auch übereinander in mehreren Substratebenen angebracht sein können. Das einfachte Halbleiterbauelement, bzw. auch als erste Submodul bezeichnet, besteht deshalb aus einer beidseitig mit mindestens einem Halb- leiterchip mit Kontaktpads auf einer Oberseite bestüchten Trägerlage, zwei Zwischenlagen und zwei Decklagen, aus Außenkontakten und einer Leiterbahnanordnungen, wobei die Leiterbahnen die elektrische Verbindung zwischen den Kontaktpads des Halbleiterchips und den Außenkontakten herstellten.

Die Zwischenlagen weisen mindestens eine Öffnung auf. Diese mindestens eine Öffnung dient zur Aufnahme des jeweils mindestens einen Halbleiterchips. Die Leiterbahnanordnung befindet sich auf der Trägerlage. Die Zwischenlage, die Trägerlage und die Decklage sind übereinander liegend miteinander verbunden. Weiterhin ist das Submodul dadurch gekennzeichnet, daß die Leiterbahnen der Trägerlage zum einen in einem Bereich in der Nähe der Halbleiterchips, zum anderen in einem Randbereich des Halbleiterbauelementes enden.

Vorteilhaft bei einer derartigen Ausgestaltung des Bauelements ist es, daß sich das Halbleiterbauelement mit bekannten Fertigungsmethoden und Materialien herstellen läßt. Die Trägerlage besteht aus einer ganz oder teilweise durchoxidierten Aluminiumfolie, auf deren Oberseite Leiterbahnen geätzt oder gedruckt sind. Hierzu können die Fertigungsmethoden des printed-circuit-boards (PCB) verwendet werden. Die Zwischenlage besteht ebenso wie die Trägerlage aus der ganz oder teilweise durchoxidierte Aluminiumoxidfolie. Die zumindest teilweise durchoxidierte Aluminiumfolie weist den Vorteil auf, daß die Wärmeausdehnungkoeffizienten besser an die Werte von Halbleiterchips und Kunststoffpressmasse angepaßt sind. Weiterhin übernimmt die Aluminiumfolie eine Isolierung der einzelnen Lagen gegeneinander. Verbleibt ein metallischer Aluminiumkern in der teilweise durchoxidierten Aluminiumfolie, so übernimmt dieser eine elektrische Abschirmung der übereinander befindlichen Zwischenlagen bzw. Trägerlagen. Weiterhin wird ein Feuchteeinschluß verhindert. Ein weiterer Vorteil ist eine gegenüber der Verwendung von FR4 - einem gebräuchlichen Substrat - kostengünstigere Herstellung der Aluminiumfolie. In die Zwischenlage sind Öffnungen gestanzt oder geprägt; es kann auch jedes andere bekannte Fertigungsverfahren angewendet werden. Auch dieser Herstellungsschritt ist bekannt. Die Decklage besteht aus einem Material, das Wärme gut ableitet und das vom thermischen Ausdehnungskoeffizienten gut an die Werte von Trägerlage und Zwischenlage angepasst ist.

Ein Halbleiterbauelement kann sich nun aus mehreren Submodulen zusammensetzen (Multichipmodul). Ein Submodul besteht aus einer Trägerlage, auf dem ein- bzw. beidseitig eine Zwischenlage auflaminiert ist sowie einer bzw. zwei Decklage(n). Die Decklage bzw. Decklagen wird (werden) auf der anderen Seite der Zwischenlage(n) aufgebracht und bildet bzw. bilden den Abschluss des Submoduls. Dies bedeutet, dass die eine Seite einer Zwischenlage die Decklage aufweist, die andere Seite einer Zwischenlage die Trägerlage aufweist. Da sowohl die Decklage als auch die Trägerlage eine plane Oberfläche besitzen, können mehrere dieser ein- oder beidseitig ausgeführten Submodule zu einem Multichipmodul zusammengefügt werden. Das einseitige Submodul besteht aus einer Trägerlage, bei dem auf einer Seite eine Zwischenlage aufgebracht ist, die ihrerseits durch eine Decklage bedeckt ist. Ein zweiseitiges Submodul ist dadurch gekennzeichnet, daß die Trägerlage auf beiden Seiten mit einer Zwischenlage versehen ist, wobei die jeweils noch freie Seite der zwei Zwischenlagen durch jeweils eine Decklage bedeckt wird.

Da jede Zwischenlage zumindest eine Öffnung aufweist, in der jeweils mindestens ein Halbleiterchip eingebracht ist, wird durch das Zusammenfügen mehrerer Submodule übereinander ein Stapeln von Halbleiterchips in der dritten Dimension erreicht. Hierdurch ist bei einem geringen Volumenbedarf eine hohe Packungsdichte des Halbleiterbauelementes erzielt.

Die in der Nähe des zumindest einen Halbleiterchips liegenden Leiterbahnenden sind so auf der Trägerlage aufgebracht, daß die Leiterbahnenden innerhalb der in der Zwischenlage befindlichen Öffnung oder Öffnungen zum liegen kommen.

Bei einem beidseitigen Submodul sind die Leiterbahnen auf beiden Seiten der Trägerlage aufgebracht. Es ist jedoch auch bei einem einseitigen Submodul denkbar, daß die Leiterbahnanordnung auf beiden Seiten der Trägerlage aufgebracht ist. Dies bringt den Vorteil mit sich, daß die Leiterbahnführung flexibler erfolgen kann.

Ein weiterer Vorteil des erfindungsgemäßen Halbleiterbauelementes besteht darin, daß die Trägerlage ähnlich einem PCB aufgebaut ist. Dies erlaubt es, sowohl gehäuste als auch ungehäuste Halbleiterchips in das Halbleiterbauelement zu integrieren. Die Halbleiterchips können sowohl mittels eines Flip-Chip-Prozesses auf die Trägerlage aufgebracht werden, als auch mit ihrer nicht strukturierten Rückseite auf die Trägerlage aufgeklebt oder laminiert werden und durch einen Wirebondprozess oder ein Spiderband mit den Leiterbahnen elektrisch verbunden werden. Die in den Öffnungen liegenden Halbleiterchips können nach dem elektrischen Kontaktieren von einer Kunststoffpressmasse umgeben sein oder, falls die Zuverlässigkeit gewährleistet ist, auch ohne die Pressmasse in der Öffnung liegen.

In einer vorteilhaften Ausgestaltung des Halbleiterbauelementes ist auf der Trägerlage zumindest ein passives Bauelement integriert. Die passiven Bauelemente können zum Beispiel elektrische Widerstände, Kapazitäten oder ähnliches sein.

Vorteilhafterweise reicht die Decklage zumindest an einer Seite, an der keine Außenkontakte angeordnet sind, über die Zwischenlage und die Trägerlage hinaus. In diesem Fall ist die Decklage als Wärmeverteiler ausgeführt. Je nach abzuführender Verlustleistung des Halbleiterbauelementes kann der über die Zwischenlage und die Trägerlage hinausreichende Wärmeverteiler optimiert werden. Die größte Wärmeverlustleistung kann dann abgeführt werden, wenn die Decklage an allen Seiten, an der keine Außenkontakte angeordnet sind, über die Zwischenlage und die Trägerlage hinausreicht.

Die Trägerlage ragt an der Seite, an der die Außenkontakte des Halbleiterbauelementes angeordnet sind, über die Zwischenlage und die Decklage hinaus. Hierdurch können die Außenkontakte als Steckverbindungen ausgeführt werden. Werden die Leiterbahnen bis an das Ende des Trägerlage herangeführt, kann nach Aufbringen von Metallisierungen an den Enden der Leiterbahnen eine Steckverbindung, die auf einen Baugruppenträger elektrisch kontaktiert wird, hergestellt werden. Es ist jederzeit auch denkbar, daß die Außenkontakte als Pins ausgeführt werden. Werden die Metallisierungskontakte der Steckverbindung auf beiden Seiten gegenüberliegend auf der Trägerlage angebracht, so ist es denkbar, daß beide Metallisierungen dasselbe elektrische Signal führen oder daß jede der beiden Metallisierungen ein eigenes elektrisches Signal führt. Dies ist vor allem dann günstig, wenn die Leiterbahnen beidseitig auf der Trägerlage angebracht sind. Um ein korrektes Anbringen des Halbleiterbauelementes auf einem Baugruppenträger sicherzustellen weist die Trägerlage eine mechanische Kodierung, zum Beispiel in Form von einer Aussparung oder eines ausgeschnittenen Vielecks an einer Eckseite auf. Die mechanische Kodierung kann dabei jede erdenkliche Form annehmen, sofern sichergestellt ist, daß ein falsches Kontaktieren auf dem Baugruppenträger verhindert wird.

Um die Anzahl der Außenkontakten möglichst gering zu halten, und um damit das Aufbringen und den Verlauf der Leiterbahnanordnung zu vereinfachen, ist es vorteilhaft, daß alle im Halbleiterbauelement befindlichen Halbleiterchips über eine gemeinsame Leiterbahn versorgt werden. Dies bedeutet, daß bei n Halbleiterchips (n-1)*2 Außenkontakte eingespart werden können. Leiterbahnen innerhalb des Halbleiterbauelementes sorgen für die elektrische Verbindung der mit den jeweiligen Außenkontakte zur Versorgung dienenden Kontaktpads der Halbleiterchips.

In dem erfindungsgemäßen Halbleiterbauelement können Halbleiterchips verschiedener Art enthalten sein. Dies können beispielsweise Speicherchips und/oder Prozessoren sein. Die Halbleiterchips können untereinander mittels Leiterbahnen verbunden sein, sofern die Halbleiterchips in einer Ebene liegen. Mittels Durchkontaktierungen, die sich in der Trägerlage oder den Zwischenlagen befinden, ist es möglich, Halbleiterchips, die sich in unterschiedlichen Ebenen befinden elektrisch miteinander zu verbinden. Sollen Halbleiterchips, die sich in unterschiedlichen Submodulen befinden, miteinander verbunden werden, so weisen die Decklage und die Trägerlage sogenannte Kontaktinterfaces auf. Die Kontaktinterfaces sind dabei so angebracht, daß diese beim Verbinden der Trägerlage eines Submoduls mit der Decklage eines anderen Submoduls genau übereinanderliegen. Wird die Verbindung der beiden Submodule mittels eines anisotropen Klebers vorgenommen, so ist gleichzeitig die elektrische Verbindung der Kontaktinterfaces von beiden Zwischenlagen sichergestellt. Zur elektrischen Verbindung können ebenso Lötpasten oder Lötkugeln verwendet werden, wobei die Verbindung zwei Submodule dann auch mittels Klebung oder Lamination hergestellt werden kann. Ein anisotroper Leitkleber hat die vorteilhafte Eigenschaft, daß er z.B. in Y-Richtung leitend ist, während er in der X-Ebene elektrisch isolierend ist. Gleichzeitig übernimmt er die feste mechanische Verbindung zwischen einer Trägerlage und einer Decklage. Die Kontaktinterfaces sind elektrisch mit einer Durchkontaktierung verbunden, die ihrerseits mit einer Leiterbahn auf einer Trägerlage elektrisch leitend verbunden sind.

Der Vorteil des erfindungsgemäßen Halbleiterbauelementes besteht darin, daß in einem Submodul funktional zusammen gehörende Gruppen untergebracht werden können. Es können Halbleiterchips unterschiedlicher Art, zum Beispiel Speicherbausteine mit Prozessoren in einem Submodul kombiniert werden; weiterhin ist es möglich, passive Bauelemente in einem Submodul zu integrieren. Dadurch, daß die beiden Seiten eines Submodules - bei einem einseitigen Submodul bestehend aus Decklage und Trägerlage, bei einem zweiseitigen Submodul bestehend aus zwei Decklagen - plan sind, können mehrere Submodule übereinander gebracht, verbunden und zu einem sehr kompakten Multichipmodul kombiniert werden. Durch die kompakte Anordnung der einzelnen Halbleiterchips in einem oder in mehreren Submodulen bzw. der passiven Bauelemente ist eine sehr gute Signalperformance aufgrund der kurzen Signallängen vor allem bei höheren Frequenzen gewährleistet. Weiterhin besteht die Möglichkeit, Halbleiterchips sowohl in einem Submodul elektrisch miteinander zu verbinden, als auch über Kontaktinterfaces Halbleiterchips in verschiedenen Submodulen miteinander zu verbinden. Bei einem zweiseitigen Submodul können zwischen zwei Halbleiterchips sehr kurze Signalwege geschaffen werden, wenn diese gespiegelt auf dem Trägerlage angebracht werden, und die elektrischen Kontakte mittels Durchkontaktierungen durch die Trägerlage miteinander verbunden werden. Weiterhin ist eine gute Wärmeableitung durch die integrierten Decklagen, die auf jeder Zwischenlage angebracht sind, sichergestellt. Dadurch, daß mehrere Submodule übereinander angebracht sind, ist eine geringere Verformung des komplett bestückten und versiegelten Multichipmoduls gewährleistet. Eine kostengünstige Herstellung des Multichipmoduls ist möglich, da bekannte Herstellungstechnologien und Fertigungsgerätschaften verwendet werden können. Durch den modularen Aufbau aus den Submodulen ist eine flexible Kombination verschiedener funktioneller Baugruppen möglich.

Im folgenden soll ein Verfahren zum Herstellen eines zweiten (einseitigen) Submodul beschrieben werden. In einem ersten Schritt wird eine Trägerlage mit einer Leiterbahnanordnung und, falls erwünscht, mit passiven Bauelementen bestückt. Anschließend wird die Trägerlage mit einer Zwischenlage, die mindestens eine Öffnung aufweist, verbunden. Das Verbinden geschieht vorzugsweise durch Laminieren. In die Öffnung der Zwischenlage wird mindestens ein Halbleiterchips eingebracht, der mit der Trägerlage verbunden wird. Der Halbleiterchip kann dabei mit seiner strukturierten Seite (face down) oder mit seiner Rückseite auf der Trägerlage aufgebracht werden. Anschließend wird der Halbleiterchip elektrisch mit den Leiterbahnen kontaktiert. Die Enden der Leiterbahnen sind so auf der Trägerlage aufgebracht, daß sie in die Öffnung der Zwischenlage hineinragen. Nach dem elektrischen Kontaktieren kann die Öffnung mit einer Kunststoffpressmasse ausgegossen werden oder auch nicht. In einem letzten Schritt wird eine Decklage auf die Zwischenlage aufgebracht, wobei die zumindest eine Öffnung der Zwischenlage bedeckt wird. Die Decklage wird fest mit der Zwischenlage, zum Beispiel durch Laminieren verbunden. In einem letzten Schritt werden Metallisierungen auf die Enden der Leiterbahnen, die sich auf der Trägerlage befinden, die an der Seite, an der die Außenkontakte vorgesehen sind, über die Decklage und die Zwischenlage hinausreicht, aufgebracht.

Soll ein erstes (zweiseitiges) Submodul hergestellt werden, so wird auf der zweiten Seite der Trägerlage eine Zwischenlage mit mindestens einer Öffnung aufgebracht, in der wiederum jeweils mindestens ein Halbleiterchip eingebracht wird, elektrisch mit den Leiterbahnen verbunden. Anschließend wird auf der zweiten Zwischenlage eine Decklage, die vorzugsweise an allen Seiten, an der keine Außenkontakte des Multichipmoduls untergebracht sind, über die Trägerlage und die zwei Zwischenlagen hinausreicht, aufgebracht. Die Metallisierungen auf der Trägerlage, die die Außenkontakte bilden, können ein oder zweiseitig auf der Trägerlage angebracht sein.

Ein zweites Herstellungsverfahren unterscheidet sich von dem eben beschriebenen Verfahren dadurch, daß auf der Trägerlage, die die Leiterbahnen und die passiven Bauelemente aufweist, zuerst die Halbleiterchips auf diese aufgebracht und fest verbunden werden. Anschließend werden die Kontaktpads der Halbleiterchips zum Beispiel mittels Bonddrähten mit den Leiterbahnen der Zwischenlagen verbunden. Die Halbleiterchips können dabei ein oder beidseitig auf die Trägerlage aufgebracht worden sein. Erst dann wird ein- oder zweiseitig jeweils eine Zwischenlage, die Öffnungen an den Stellen der Halbleiterchips auf dem Trägerlage aufweist, auf die Trägerlage aufgebracht und mit diesem zum Beispiel durch Läminieren, verbunden. Die in den Öffnungen liegenden Halbleiterchips können durch Pressmasse ausgegossen werden. Die weiteren Fertigungsschritte laufen entsprechend dem ersten Herstellungsverfahren ab.

Hat man nach einem der beiden beschriebenen Fertigungsverfahren mehrere Submodule gefertigt, so können mehrere Submodule zu einem Multichipmodul verbunden werden. Basis ist dabei ein erstes (zweiseitiges) Submodul, auf dem jeweils ein oder mehrere einseitige Submodule aufgebracht werden. Dies bedeutet, daß das Multichipmodul auf beiden gegenüberliegenden Seiten immer durch eine Decklage abgeschlossen ist. Zwei Submodule werden immer so zusammengefügt, daß eine Decklage eines zweiseitigen Submoduls mit einer Decklage eines anderen zweiseitigen Submoduls oder mit einer Trägerlage eines einseitigen Submoduls verbunden ist.

Nachfolgend wird die Erfindung anhand von Ausführungsbeispielen unter Bezugnahme auf die Figuren näher erläutert.

Es zeigen:
- Figur 1-3 ein: zweites (einseitiges) Submodul im Querschnitt,
- Figur 4 und 5: ein Halbleiterbauelement im Querschnitt, bestehend aus einem einzigen ersten (zweiseitigen) Submodul,
- Figur 6 ein: Halbleiterbauelement in Draufsicht,
- Figur 7 ein: Halbleiterbauelement (Multichipmodul) im Querschnitt, bestehend aus zwei einseitige und einem zweiseitigen Submodul und
- Figur 8 ein: Halbleiterbauelement im Querschnitt mit einer Variante bei den Bauelementkontakten.

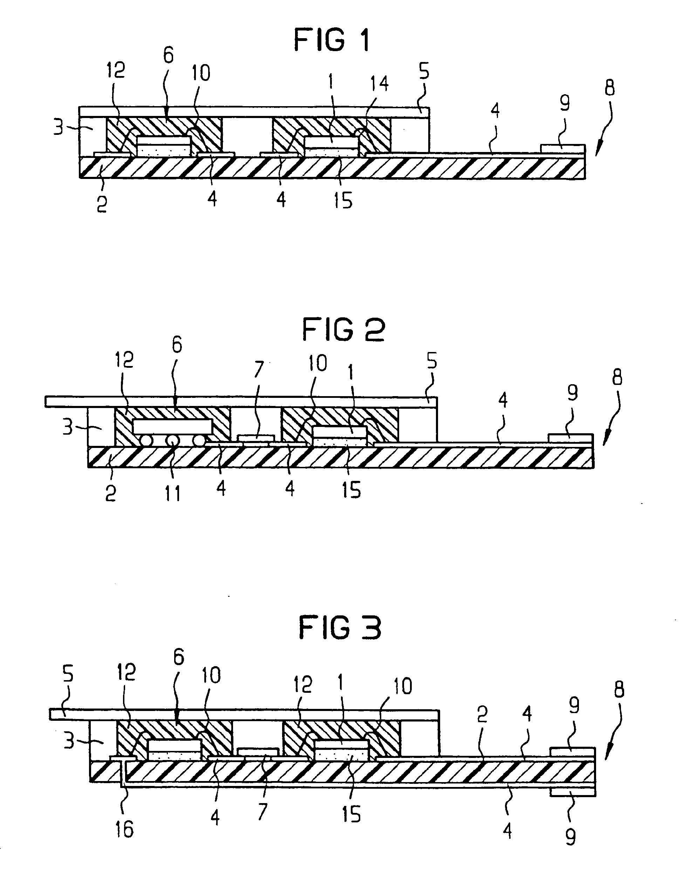

Figur 1 zeigt ein zweites (einseitiges) Submodul. Die Trägerlage 2 weist auf einer Seite Leiterbahnen 4 auf. Auf der Seite, auf der die Leiterbahnen 4 aufgebracht sind, ist eine Zwischenlage 3, die Öffnungen 6 aufweist, auflaminiert. Die Zwischenlage 3 ist durch eine Decklage 5 abgeschlossen. In die Öffnungen 6 sind Halbleiterchips 1 eingebracht und mit der Zwischenlage 2 mittels eines Klebers 15 verbunden. In der gezeichneten Darstellung sind die Halbleiterchips 1 mit ihrer nichtleitenden Rückseite auf die Zwischenlage 2 geklebt. Es ist auch eine andere Befestigungstechnik als Klebung denkbar. Die auf den Halbleiterchips 1 befindlichen Kontaktpads 14 sind mittels Bonddrähten 10 mit den Leiterbahnen 4 elektrisch verbunden. Die Öffnungen 6 sind mittels einer Kunststoffpressmasse 12 abgeschlossen. Die Decklage 5 schließt an den Seiten, an denen keine Außenkontakte 8 angebracht sind, mit der Zwischenlage 3 ab. Die Trägerlage 2 ist an der Seite, an der die Außenkontakte 8 angebracht sind über die Decklage 5 und die Zwischenlage 2 hinaus verlängert, wobei die Leiterbahnen 4 bis zum Ende der Trägerlage 2 reichen. An den Enden der Leiterbahnen 4 sind Metallisierungen 9 aufgebracht, die in Form von Steckverbindungen die Außenkontakte 8 darstellen. Die in der Figur eingezeichneten Halbleiterchips 1 können mittels Leiterbahnen 4 miteinander elektrisch verbunden sein, oder auch nicht. Die in die Nähe der Halbleiterchips 1 liegenden Leiterbahnenden 4 liegen dabei innerhalb der jeweiligen Öffnungen 6.

Figur 2 zeigt ein einseitiges Submodul. Figur 2 unterscheidet sich von Figur 1 dadurch, daß die Decklage 5 zumindest an der den Außenkontakten 8 gegenüberliegenden Seite über die Zwischenlage 3 hinaus verlängert ist, um eine höhere Wärmeverteilung zu erzielen. Weiterhin sind auf der Trägerlage 2, auf der die Leiterbahnen 4 zum Beispiel gedruckt oder geätzt sind, passive Bauelemente 7 aufgebracht. Figur 2 zeigt in der einen Zwischenlage 3 zwei Öffnungen 6, in der sich jeweils ein Halbleiterchip 1 befindet. Einer der Halbleiterchips 1 ist mittels Flip-Chip-Kontaktierung 11 auf der Trägerlage 2 befestigt und elektrisch mit den Leiterbahnen 4 verbunden. Der andere Halbleiterchip 1 ist mit seiner Rückseite auf die Trägerlage 2 geklebt und mittels Bonddrähten 10 mit den Leiterbahnen 4 elektrisch verbunden. Die beiden Öffnungen 6 sind mittels Kunststoffpressmasse 12 ausgegossen, um die Zuverlässigkeit des Halbleiterbauelementes sicher zu stellen, z.B. durch eindringende Feuchtigkeit in die Öffnungen 6. Es ist jederzeit denkbar, daß die Trägerlage 2 mehr als zwei Öffnungen 6 aufweist, und daß in einer Öffnung 6 auch mehrere Halbleiterchips 1 untergebracht sind.

Figur 3 zeigt ein einseitiges Submodul. Die Trägerlage 2 weist auf beiden Seiten Leiterbahnen 4 auf. Auf einer Seite der Trägerlage 2 ist eine Zwischenlage 3, die Öffnungen 6 aufweist, aufgebracht. In den Öffnungen 6 liegt jeweils ein Halbleiterchip 1, der mit seiner nichtleitenden Rückseite auf die Zwischenlage 2 mittels Kleber 15 befestigt ist. Die Halbleiterchips 1 sind mittels Bonddrähten 10 mit den Leiterbahnen 4 elektrisch verbunden. Auf der Seite, auf der die Zwischenlage 3 auf der Trägerlage 2 befestigt ist, weist die Trägerlage 2 passive Bauelemente 7, die zum Beispiel Widerstände oder Kondensatoren sein können, auf. Die Decklage 5 ragt zumindest an der Seite, an der keine Außenkontakte 8 angebracht sind, über die Zwischenlage 3 und die Trägerlage 2 hinaus, um eine größere Wärmeabfuhr zu erzielen. Die auf der unteren Seite der Trägerlage 2 befindlichen Leiterbahnen 4 sind mittels Durchkontaktierungen 16 durch die Trägerlage 2 mit Leiterbahnen 4 auf der Oberseite der Trägerlage 2 verbunden. Die beidseitige Leiterbahnführung auf der Trägerlage 2 bringt den Vorteil, daß auf beiden Seiten der Außenkontakte 8 eine Metallisierung 9 aufgebracht werden kann, und somit die Leiterbahnführung flexibler ausgelegt werden kann. Hierdurch ergibt sich der Vorteil, daß die doppelte Anzahl an externen Außenkontakten erzeugt werden kann, ohne daß der Abstand zwischen zwei Leiterbahnen 4 bzw. zwei Metallisierungen 9 verkleinert werden müßte.

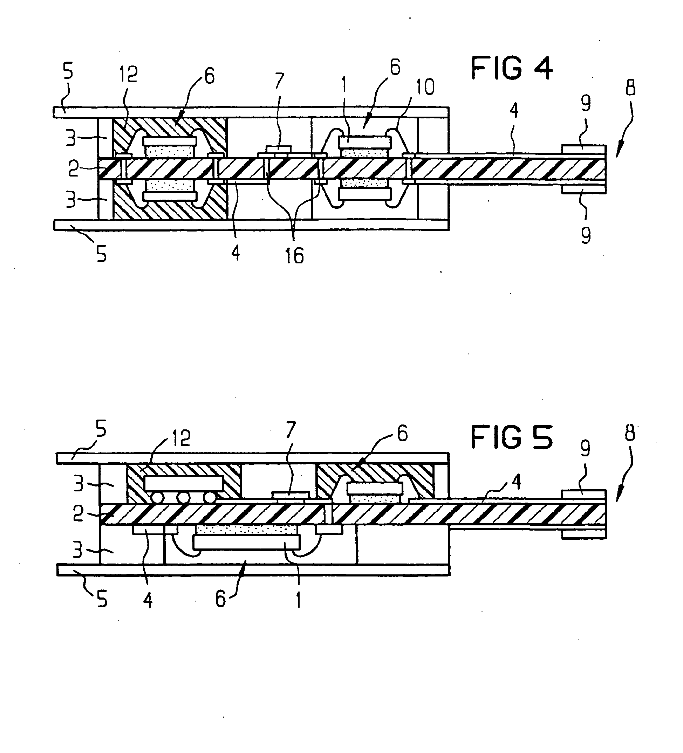

Figur 4 zeigt ein Halbleiterbauelement im Querschnitt, bestehend aus einem ersten (beidseitigen) Submodul. Auf der Trägerlage 2 sind beidseitig Leiterbahnen 4 sowie passive Bauelemente 7 (nur auf einer Seite sichtbar) aufgebracht. Auf beiden Seiten der Trägerlage 2 befindet sich jeweils eine Zwischenlage 3, die jede eine bestimmte Anzahl an Öffnungen 6 aufweist. In jede der Öffnungen 6 ist zumindest ein Halbleiterchip 1 eingebracht und mit der Trägerlage 2 verbunden. In der dargestellten Zeichnung sind alle Halbleiterchips 1 mit ihrer nichtleitenden Rückseite mittels Kleber 15 auf der Trägerlage 2 befestigt. Die elektrische Kontaktierung aller Halbleiterchips 1 ist mittels Bonddrähten 10 von den Kontaktpads 14 der Halbleiterchips 1 auf die Leiterbahnen 4 vorgenommen. Auf jede der beiden Zwischenlagen 3 ist eine Decklage 5 aufgebracht, die die Zwischenlage 3 mit den Öffnungen 6 bedeckt. Die Decklagen 5 reichen an den Seiten, an denen keine Außenkontakte 8 am Halbleiterbauelement angebracht sind über die Zwischenlagen 3 und die Trägerlage 2 hinaus. Halbleiterchips 1, die nicht in der gleichen Zwischenlage 3 liegen, können mittels Durchkontaktierungen 16 untereinander verbunden sein. Die Durchkontaktierungen 16 können jedoch auch nur dazu dienen, die Leiterbahnführung zu optimieren. Es ist nicht zwangsweise notwendig, daß jede Durchkontaktierung eine Chipto-Chipverbindung herstellt. In der dargestellten Figur ist nur ein passives Bauelement auf der Trägerlage 2 dargestellt. Es ist jedoch selbstverständlich möglich, daß beidseitig der Trägerlage 2 passive Bauelemente aufgebracht sind. Die Außenkontakte 8 sind wie in den vorangegangenen Zeichnungen als Steckverbindungen ausgeführt, das heißt die Leiterbahnenden 4 weisen Metallisierungen 9 auf, über die ein Baugruppenträger kontaktiert werden kann. Zwei der dargestellten vier Öffnungen 6 sind mit Pressmasse 12 ausgegossen. In den zwei anderen Öffnungen 6 liegen die Halbleiterchips 1 ohne umgebenden direkten Schutz. Sofern sichergestellt ist, daß, zum Beispiel durch eindringende Feuchtigkeit, die Zuverlässigkeit des Halbleiterbauelements nicht beeinträchtigt ist, muß die Öffnung 6 nicht mit der Pressmasse 12 ausgegossen werden.

Allen dargestellten Ausführungsbeispielen ist gemeinsam, daß diese aus einer Trägerlage, zumindest einer Zwischenlage und zumindest einer Decklage bestehen. Dies bedeutet, ein Submodul wird entweder von zwei Decklagen abgeschlossen oder aber durch eine Decklage und die Trägerlage. Die Submodule weisen eine absolut plane Oberfläche auf, so daß mehrere der dargestellten Submodule zu einem größeren Halbleiterbauelement verbunden werden können. Zumindest ein erstes (zweiseitiges) Submodul ist in einem Halbleiterbauelement nach der Erfindung vorhanden. Der modulare Aufbau aus Submodulen bringt den Vorteil mit sich, daß funktionell zusammengehörende Bauteile in einem Submodul integriert werden können. Der Funktionsumfang eines Halbleiterbauelementes kann auf diese Weise durch Zusammenfügen mehrerer Submodule leicht erweitert werden. Weiterhin wird durch das Vorsehen eines integrierten Wärmeverteilers in Form der Decklage der thermische Streß auf das Bauelement verringert. Je nach Ausgestaltung des Wärmeverteilers kann eine optimale Wärmeableitung erzielt werden.

Figur 5 zeigt ein Halbleiterbauelement in einer leicht abgewandelten Form eines beidseitigen Submodules. Figur 5 unterscheidet sich gegenüber Figur 4 nur dadurch, daß eine von beidseitig auf der Trägerlage 2 aufgebrachten Zwischenlagen 3 nur eine Öffnung 6 enthält, in der im Querschnitt ein Halbleiterchip 1 zu erkennen ist. Die andere Zwischenlage weist in Analogie zu Figur 4 zwei Öffnungen 6 auf, in der jeweils ein Halbleiterchip 1 untergebracht ist. Eine der beiden Halbleiterchips 1 ist mittels Flip-Chip-Kontaktierung 11, der andere mittels Bonddrähten 10 elektrisch mit den Leiterbahnen 4 verbunden. Auch in Figur 5 ist nur auf einer Seite der Trägerlage 2 ein passives Bauelement 7 aufgebracht. Es ist jedoch denkbar, daß auch auf der anderen Seite der Trägerlage 2 passive Bauelemente 7 integriert sind. Der in der unteren Zwischenlage 3 liegende Halbleiterchip 1 ist in seiner Öffnung 6 nicht von Pressmasse 12 umgeben. Die übrigen Merkmale des in Figur 5 gezeigten Halbleiterbauelementes unterscheiden sich nicht von den bisher beschriebenen Submodulen.

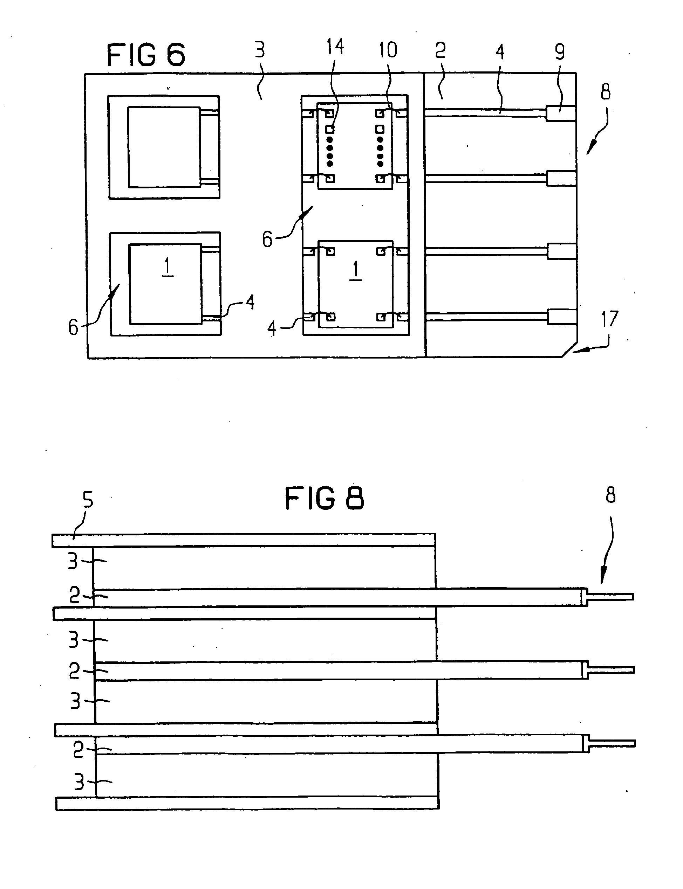

Figur 6 zeigt ein Halbleiterbauelement in einer Draufsicht. Der besseren Übersichtlichkeit halber wurde die Decklage 5, die auf der Zwischenlage 3 aufgebracht ist und die Öffnungen 6 verschließt, weggelassen. Die Zwischenlage 3 weist in dem ausgeführten Beispiel drei Öffnungen 6 auf, wobei in zwei Öffnungen jeweils ein Halbleiterchip 1 liegt, und in einer großen Öffnung 6, die auf der rechten Seite der Zwischenlage 2 liegt, zwei Halbleiterchips 1 liegen. Weiterhin zeigt das Ausführungsbeispiel Leiterbahnen 4, die auf der Zwischenlage 2 aufgebracht sind, und an den Enden des Halbleiterbauelementes mit Metallisierungen 9, die als Außenkontakte 8 dienen, versehen sind. Die Außenkontakte 8 weisen eine Kodierung 17 in Form einer abgeschnittenen Ecke auf. Die mechanische Kodierung 17 dient dazu, ein falsches Einstecken des Halbleiterbauelementes auf einem Baugruppenträger zu verhindern. Die mechanische Kodierung 17 kann auch in Form einer Aussparung oder in Form eines abgeschnittenen Vielecks oder jeder anderen mechanischen Ausführung erfolgen, die sicherstellt, daß ein falsches Kontaktieren des Halbleiterbauelementes auf einem Baugruppenträger sichergestellt ist. Die in der großen Öffnung 6 liegenden zwei Halbleiterchips 1 sind mit ihrer nichtleitenden Rückseite auf dem Trägerlage 2 befestigt. Die auf dem Halbleiterchip 1 befindlichen Kontaktpads 14 sind mittels Bonddrähten 10 elektrisch mit den Leiterbahnen 4 verbunden. Die Leiterbahnenden reichen dabei in den Bereich der Öffnung 6 hinein. Die in den anderen beiden Öffnungen 6 liegenden Halbleiterchips 1 sind mittels eines Flip-Chip-Prozesses mit der Trägerlage 2 und den Leiterbahnen 4 elektrisch und mechanisch kontaktiert.

In einer vorteilhaften Ausgestaltung ist es sinnvoll, daß die Vielzahl (n) an Halbleiterchips 1 durch gemeinsame Leiterbahnen 4 versorgt werden. Dies bringt den Vorteil mit sich, daß die Anzahl der Außenkontakte 8 bzw. der Metallisierungen 9 um die (n - 1)*2 verringert werden kann. Dies bedingt jedoch eine interne Verbindung der Kontaktpads 14 der Halbleiterchips 1 untereinander mittels Leiterbahnen 4 und/oder durch Kontaktierungen 16.

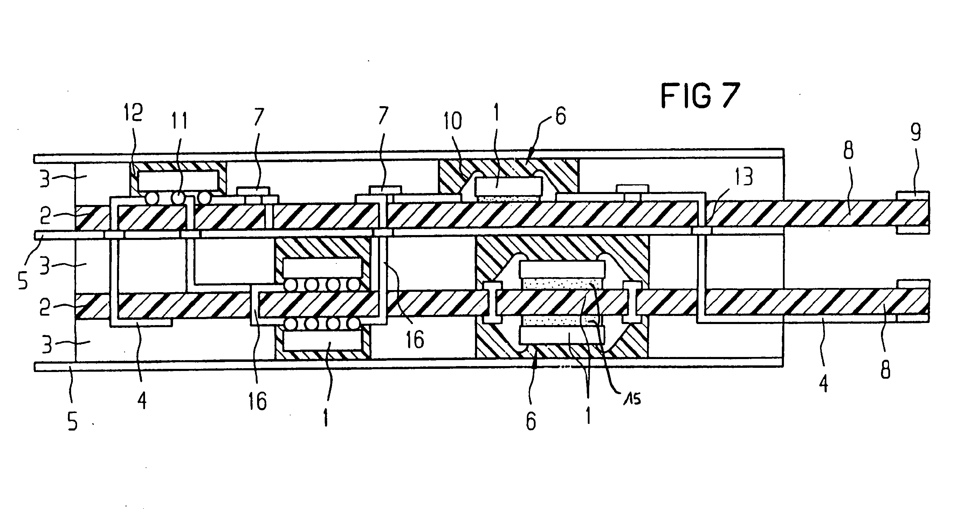

Figur 7 zeigt ein Halbleiterbauelement im Querschnitt, wobei dieses sich aus zwei Submodulen zusammensetzt. Basis des erfindungsgemäßen Halbleiterbauelementes ist ein erstes (beidseitiges) Submodul, auf das ein zweites (einseitiges) Submodul aufgebracht ist. Das beidseitige Submodul besteht aus einer Trägerlage 2, die auf beiden Seiten Leiterbahnen 4 sowie, falls erwünscht, passive Bauelemente 7, aufweist. Jede Zwischenlage 3 weist zwei Öffnungen 6 auf, in die jeweils ein Halbleiterchip 1 eingebracht ist. Im Bild ist eine besonders vorteilhafte Ausgestaltung dargestellt, wenn die Halbleiterchips 1 untereinander verbunden werden sollen. Die kürzesten Signalwege lassen sich dann erreichen, wenn die Halbleiterchips 1 gespiegelt auf der Trägerlage 2 aufgebracht sind. In der Figur sind in den rechten Öffnungen die Halbleiterchips 1 mit ihren nichtleitenden Rückseiten auf der Trägerlage 2 mittels Kleber 15 befestigt und über Bonddrähte 10 auf Leiterbahnen 4 elektrisch verbunden. Die Leiterbahnen 4, die gespiegelt auf der Trägerlage 2 angebracht sind, sind mittels Durchkontaktierungen 16 miteinander verbunden. Hierdurch lassen sich extrem kurze Signallaufzeiten erreichen, was vor allem bei hohen Frequenzen von Vorteil ist. In den beiden linken Öffnungen 6 sind die Halbleiterchips 1 mittels Flip-chip-Kontaktierung 11 auf dem Trägerlage 2 befestigt und elektrisch mit den Leiterbahnen 4 verbunden. Auch hier liegt eine gespiegelte Anordnung vor. Mittels Durchkontaktierungen 16 lassen sich sehr kurze Signallaufzeiten erreichen. Diese sind sogar noch kürzer, als wenn die Halbleiterchips 1 mittels Bonddrähten elektrisch kontaktiert sind. Das beidseitige Submodul weist auf jeder der Zwischenlagen 3 eine Decklage 5 auf, die an der den Außenkontakten 8 gegenüberliegenden Seite über die Zwischenlagen 3 und die Trägerlage 2 hinaussteht. Die Zwischenlagen 3, die Trägerlage 2 und die Decklage 5 sind mittels Lamination fest verbunden. Die Öffnungen 6, in denen sich die Halbleiterchips 1 befinden, sind mit Pressmasse 12 ausgegossen. Weiterhin besteht das Halbleiterbauelement aus einem zweiten (einseitigen) Submodul, wobei dessen Trägerlage 2 mit einer der Decklagen 5 des beidseitigen Submoduls verbunden ist. Sollen die Halbleiterchips des einseitigen Submoduls mit den Halbleiterchips 1 oder Leiterbahnen 4 des beidseitigen Submoduls verbunden werden, so übernehmen Kontaktinterfaces 13, die sich sowohl an der Unterseite der Trägerlage 2 als auch auf der entsprechenden Decklage 5 befinden, die Verbindung. Die Kontaktinterfaces 13 sind jeweils mit einer Durchkontaktierung 16 verbunden. Werden zwei Submodule z.B. mittels eines anisotropen Leitklebers miteinander verbunden, so ist neben einer festen Verbindung der beiden Submodule gleichzeitig die elektrische Verbindung an den Kontaktinterfaces 13 sichergestellt. Es ist jedoch auch denkbar, daß an Stellen der Kontaktinterfaces 13 Lötkugeln oder Lötpasten aufgetragen werden, die beim Zusammenfügen der beiden Submodule die elektrische Verbindung übernehmen. In der dargestellten Figur sind zwei Submodule miteinander verbunden. Es ist jedoch jederzeit denkbar, daß, ausgehend von einem zweiseitigen Submodul, beliebig viele einseitige Submodule aufeinander aufgebracht werden, um das Bauelement somit in der dritten Dimension erweitern. Die einseitigen Submodule können dann auch an den Decklagen 5 weitere Kontaktinterfaces 13 aufweisen, die die Halbleiterchips 1 verschiedener Submodule miteinander verbinden. Dadurch, daß in Submodulen vorteilhafterweise unterschiedliche funktionelle Baugruppen angeordnet sind, ist durch das Zusammenfügen der Submodule zu einem einzigen Halbleiterbauelement eine besonders raumökonomische Lösung gefunden.

Figur 8 zeigt ein Halbleiterbauelement im Querschnitt, das aus einem zweiseitigen Submodul und zwei einseitigen Submodulen besteht. Die einseitigen Submodule sind dabei symmetrisch auf dem beidseitigen Submodul aufgebracht. Die Symmetrie bezieht sich dabei auf die äußere Gehäuseumrandung, nicht jedoch auf die Anordnung der Halbleiterchips 1 und passiven Bauelemente 7 bzw. Leiterbahnen 4 im Inneren der Submodule. Das in Figur 8 gezeigte Halbleiterbauelement unterscheidet sich von den vorher beschriebenen Varianten durch die Ausführung der Außenkontakte 8. Anstatt einer Steckverbindung mit Metallisierungen 9, sind die Außenkontakte 8 als Pins ausgeführt. Es sind jedoch auch noch andere Außenkontaktformen denkbar als die in den Ausführungsbeispielen gezeigten Varianten.

Die Vorteile eines erfindungsgemäßen Halbleiterbauelementes bestehen darin, daß dieses aus modular aufgebauten Submodulen zusammengesetzt werden kann. Jedes einzelne Submodul - einseitiges Submodul oder zweiseitiges Submodul - kann mit bekannten Herstellungstechnologien gefertigt werden. Dies ermöglicht eine kostengünstige rationelle und schnelle Fertigung eines Submoduls. Es sind auch keine neuen Bearbeitungsmaschinen zur Herstellung der einzelnen Bauteile notwendig. Weiterhin weist das erfindungsgemäße Halbleiterbauelement den Vorteil auf, daß die komplett bestückten und versiegelten Submodule eine geringere Verformung aufweisen, als wenn die einzelnen Halbleiterbauteile - Halbleiterchips, passive Bauelemente, usw. - auf einem Baugruppenträger in einzelner Form nebeneinander aufgebracht würden. Aufgrund der kompakten Bauweise kann eine verbesserte Signalperformance, die vor allem bei höheren Frequenzen von Vorteil ist, erzielt werden. Die Submodule weisen eine niedrige Bauhöhe auf und können aufgrund der planen Flächen aufeinander gestapelt und miteinander verbunden werden.

## Patentansprüche

1. Modulweise erweiterbares Halbleiterbauelement mit einer Trägerlage (2), Zwischenlagen (3) und Decklagen (5), wobei das Halbleiterbauelement zumindest ein erstes Submodul aufweist und das erste Submodul:
- beidseitig eine zwischenlage (3) auf der Trägerlage (2) aufweist,
- eine erste Seite der Zwischenlagen (3) mit einer der Decklagen (5), eine zweite Seite der Zwischenlagen (3) jeweils mit der Trägerlage (2) verbunden ist,
- die zwischenlagen (3) mit jeweils zumindest einer Öffnung (6) versehen sind,
- in die Öffnung der zwischenlagen(3) Halbleiterchips (1) einsetzbar sind,
- zumindest ein Halbleiterchip (1) in jeder Zwischenlage (3) eingesetzt ist und mittels seiner Kontaktpads (14) mit einer auf jeder Seite der Trägerlage (2) vorgesehenen Leiterbahnanordnung (4) verbunden ist, die zu Außenkontakten (8) des Halbleiterbauelementes führt,
- das Zwischenlagenmaterial und das Trägerlagenmaterial eine teilweise durchoxidierte Aluminiumfolie mit einem metallischen Aluminiumkern ist.

2. Halbleiterbauelement nach Patentanspruch 1,
wobei die Leiterbahnanordnung (4) in einem Bereich in der Nähe des Halbleiterchips (1) und einem Randbereich des Halbleiterbauelementes endet und wobei die zumindest eine der Decklagen (5) als Wärmeverteiler ausgebildet ist.

3. Halbleiterbauelement nach Patentanspruch 2,
**dadurch gekennzeichnet, dass**
die in der Nähe des zumindest einen Halbleiterchips (1) liegenden Leiterbahnenden (4) innerhalb einer Öffnung (6) liegen.

4. Halbleiterbauelement nach einem der vorhergehenden Patenansprüche,
**dadurch gekennzeichnet, dass**
die zumindest eine Trägerlage (2) zumindest ein passives Bauelement (7) aufweist.

5. Halbleiterbauelement nach einem der vorhergehenden Patenansprüche,
**dadurch gekennzeichnet, dass**
eine der Decklagen (5) an zumindest einer Seite, an der keine Außenkontakte (8) angeordnet sind, über die Zwischenlagen (3) und die Trägerlage (2) hinausreicht.

6. Halbleiterbauelement nach einem der vorhergehenden Patentansprüche,
**dadurch gekennzeichnet, dass**
die Trägerlage (2) an der Seite, an der die Außenkontakte (8) angeordnet sind, über die Zwischenlagen (3) und die Decklagen (5) hinausreicht.

7. Halbleiterbauelement nach einem der vorhergehenden Patentansprüche,
**dadurch gekennzeichnet, dass**
alle Halbleiterchips (1) über eine gemeinsame Leiterbahn (4) versorgt werden.

8. Halbleiterbauelement nach einem der vorhergehenden Patentansprüche,
**dadurch gekennzeichnet, dass**
die Außenkontakten (8) der Trägerlage (2) eine mechanische Kodierung (17) aufweisen.

9. Halbleiterbauelement nach einem der vorhergehenden Patentansprüche,
**dadurch gekennzeichnet, dass**
die Trägerlage (2), die zwischenlagen (3) und zumindest eine der Decklagen (5) Durchkontaktierungen (16) aufweisen.

10. Halbleiterbauelement nach einem der vorhergehenden Patentansprüche,
**dadurch gekennzeichnet, dass**
signalführende Kontaktpads (14) von zumindest zwei Halbleiterchips (1) mittels der Leiterbahnanordnung (4) und/oder der Durchkontaktierungen (16) miteinander elektrisch verbindbar sind.

11. Halbleiterbauelement nach einem der vorhergehenden Patentansprüche,
**dadurch gekennzeichnet, dass**
- ein zweites Submodul mit einer Trägerlage (2), einer auf einer Seite der Trägerlage (2) aufgebrachten Zwischenlage (3), die ihrerseits durch eine Decklage (5) bedeckt ist, und mit einem in einer Öffnung der Zwischenlage eingesetzten Halbleiterchip, vorgesehen ist,
- das erste Submodul und das zweite Submodul über Kontaktinterfaces (13)elektrisch verbindbar sind, wobei ein Kontaktinterface an einer der Decklagen (5) des ersten Submoduls und ein Kontaktinterface an der Trägerlage (2) des zweiten Submoduls gegenüberliegend angeordnet sind und jedes Kontaktinterface (13) mit einer Durchkontaktierung (16) elektrisch verbunden ist, die ihrerseits mit einer Leiterbahnanordnung auf einer Trägerlage elektrisch leitend verbunden ist.

12. Halbleiterbauelement nach einem der vorhergehenden Patentansprüche,
**dadurch gekennzeichnet, dass**
die verlängerten Enden der Trägerlage (2) Außenkontakte (8) aufweisen und dass die Außenkontakte (8) ein- oder beidseitig Metallisierungen (9) aufweisen, wobei jede der beiden Metallisierungen (9) ein elektrisches Signal führt oder wobei beide Metallisierungen (9) dasselbe Signal führen.

13. Halbleiterbauelement nach einem der vorhergehenden Patentansprüche,
**dadurch gekennzeichnet, dass**
die Trägerlage (2), die Zwischenlagen (3) und die Decklage (5) mit anisotropem Leitkleber verbunden sind.

14. Verfahren zum Herstellen eines Multichipmoduls mit den Schritten:
a) Fertigen zumindest eines Halbleiterbauelements nach einem der Ansprüche 1 bis 13,
b) Fertigen zumindest eines zweiten Submoduls, wobei das zweite Submodul mit einer Trägerlage (2), einer auf einer Seite der Trägerlage (2) aufgebrachten Zwischenlage (3), die ihrerseits durch eine Decklage (5) bedeckt ist, und mit einem in einer Öffnung der Zwischenlage eingesetzten Halbleiterchip, vorgesehen ist,
c) Verbinden eines Halbleiterbauelements nach einem der Ansprüche 1 bis 13 über zumindest eine seiner zwei Decklagen mit der der Zwischenlage bestückten Seite der Trägerlage gegenüberliegenden Trägerlagenseite eines zweiten Submoduls oder
d) Verbinden zweier Halbleiterbauelemente nach einem der Ansprüche 1 bis 13 über zumindest eine ihrer zwei Decklagen.

15. Verfahren zum Herstellen eines Multichipmoduls gemäß Anspruch 14,
wobei mindestens eines der mindestens zwei zu verbindenden Submodule mit den folgenden Schritten hergestellt wird:
a) Vorsehen einer mit einer Leiterbahnanordnung (4) und zu mindest einem passivem Bauelement (7) bestückten Trägerlage (2),
b) Verbinden der Trägerlage (2) mit einer zumindest eine Öffnung (6) aufweisende Zwischenlage (3).
c) Einbringen zumindest eines Halbleiterchips (1) in die zumindest eine Öffnung (6),
d) Verbinden des zumindest einen Halbleiterchips (1) mit der Trägerlage (2),
e) elektrisches Kontaktieren des zumindest einen Halbleiterchips (1) mit der Leiterbahnanordnung (4),
f) Aufbringen und Verbinden einer Decklage (5), wobei die Zwischenlage (3) mit der zumindest einen Öffnung (6) bedeckt wird, und
g) Aufbringen von Metallisierungen (9) auf Enden der Leiterbahnen (4), die am Randbereich der Trägerlage (2) liegen.

16. Verfahren zum Herstellen eines Multichipmoduls gemäß Anspruch 15,
wobei mindestens eines der mindestens zwei Submodule mit den folgenden Schritten hergestellt wird:
a) vorsehen einer mit einer Leiterbahnanordnung (4) und zumindest einem passivem Bauelement (7) bestückten Trägerlage (2),
b) Vorsehen zumindest eines Halbleiterchips (1) auf der Trägerlage (2),
c) Verbinden des zumindest einen Halbleiterchips (1) mit der Trägerlage (2),
d) elektrisches Kontaktieren des zumindest einen Halbleiterchips (1) mit den Leiterbahnen (4),
e) Aufbringen und Verbinden der Trägerlage (2) mit einer zumindest eine Öffnung (6) aufweisende Zwischenlage (3),
f) Aufbringen und Verbinden einer Decklage (5), wobei die Zwischenlage (3) mit der zumindest einen Öffnung (6) bedeckt wird, und
g) Aufbringen von Metallisierungen (9) auf Enden der Leiterbahnen (4), die am Randbereich der Trägerlage (2) liegen.

## Claims

1. A modularly expandable semiconductor component having a carrier layer (2), intermediate layers (3) and cover layers (5), wherein the semiconductor component comprises at least one first submodule, and the first submodule:
- comprises, on both sides, an intermediate layer (3) on the carrier layer (2),
- a first side of the intermediate layers (3) is connected to one of the cover layers (5), a second side of the intermediate layers (3) respectively is connected to the carrier layer (2),
- the intermediate layers (3) are each provided with at least one opening (6),
- into the opening of the intermediate layers semiconductor chips (1) can be inserted (3),
- at least one semiconductor chip (1) is inserted into each intermediate layer (3) and, by means of the contact pads (14) thereof, is connected to a conductor path arrangement (4) provided on each side of the carrier layer (2) and leading to outer contacts (8) of the semiconductor component,
- the intermediate layer material and the carrier layer material is a partially oxidized-through aluminum foil having a metallic aluminum core.

2. The semiconductor component as claimed in claim 1, wherein the conductor path arrangement (4) terminates in an area near the semiconductor chip (1) and an edge area of the semiconductor component, and wherein the at least one of the cover layers (5) is configured as a heat distributor.

3. The semiconductor component as claimed in claim 2, **characterized in that** the conductor path ends (4) situated near the at least one semiconductor chip (1) are situated within an opening (6).

4. The semiconductor component as claimed in one of the preceding claims, **characterized in that**
the at least one carrier layer (2) comprises at least one passive component (7).

5. The semiconductor component as claimed in one of the preceding claims, **characterized in that**
one of the cover layers (5) extends beyond the intermediate layers (3) and the carrier layer (2) on at least one side at which outer contacts (8) are not arranged.

6. The semiconductor component as claimed in one of the preceding claims, **characterized in that**
the carrier layer (2) extends beyond the intermediate layers (3) and the cover layers (5) on the side at which the outer contacts (8) are arranged.

7. The semiconductor component as claimed in one of the preceding claims, **characterized in that**
the entirety of the semiconductor chips (1) are supplied via a common conductor path (4).

8. The semiconductor component as claimed in one of the preceding claims, **characterized in that**
the outer contacts (8) of the carrier layer (2) have a mechanical coding (17).

9. The semiconductor component as claimed in one of the preceding claims, **characterized in that**
the carrier layer (2), the intermediate layers (3) and at least one of the cover layers (5) comprise through-platings (16).

10. The semiconductor component as claimed in one of the preceding claims, **characterized in that**
the signal-conducting contact pads (14) of at least two semiconductor chips (1) may be electrically interconnected by means of the conductor arrangement (4) and/or the through-platings (16).

11. The semiconductor component as claimed in one of the preceding claims, **characterized in that**
- a second submodule is provided including a cover layer (2), an intermediate layer (3) applied to one side of the carrier layer (2) in turn covered by a cover layer (5), and a semiconductor chip inserted into an opening of the intermediate layer,
- the first submodule and the second submodule may be electrically connected via contact interfaces (13), wherein one contact interface is arranged at one of the cover layers (5) of the first submodule, and one contact interface is oppositely arranged at the carrier layer (2) of the second submodule, and each contact interface (13) is electrically connected to a through-plating (16) which in turn is in electrically-conducting connection with a conductor path arrangement on a carrier layer.

12. The semiconductor component as claimed in one of the preceding claims, **characterized in that**
the extended ends of the carrier layer (2) comprise outer contacts (8), and
the outer contacts (8) comprise metallizations (9) on one or both sides, wherein each of the two metallizations (9) conduct an electric signal, or wherein both of the metallizations (9) conduct the same signal.

13. The semiconductor component as claimed in one of the preceding claims, **characterized in that**
the carrier layer (2), the intermediate layers (3) and the cover layers (5) are bonded by means of anisotropic conductive glue.

14. A method of producing a multichip module, comprising the steps of:
a) manufacturing at least one semiconductor component as claimed in any one of claims 1 to 13,
b) manufacturing at least one second submodule, wherein the second submodule is provided with a carrier layer (2), an intermediate layer (3) applied to one side of the carrier layer (2) in turn covered by a cover layer (5), and a semiconductor chip inserted into an opening of the intermediate layer,
c)
- connecting a semiconductor component as claimed in any one of claims 1 to 13 via at least one of the two cover layers thereof to the carrier layer side of a second submodule opposite the intermediate layer-equipped side of the carrier layer, or
- connecting two semiconductor components as claimed in one of claims 1 to 13 via at least one of the cover layers thereof.

15. The method of producing a multichip module as claimed in claim 14, wherein at least one of the at least two submodules to be connected is produced by means of the following steps:
a) providing a carrier layer (2) equipped with a conductor path arrangement (4) and at least one passive component (7),
b) connecting the carrier layer (2) to an intermediate layer (3) comprising at least one opening (6),
c) inserting at least one semiconductor chip (1) into the at least one opening (6),
d) connecting the at least one semiconductor chip (1) to the carrier layer (2),
e) electrically bonding the at least one semiconductor chip (1) to the conductor path arrangement (4),
f) applying and connecting one cover layer (5), wherein the intermediate layer (3) having the at least one opening (6) is covered, and
g) applying metallizations (9) to ends of the conductor paths (4) situated at the edge area of the carrier layer (2).

16. The method of producing a multichip module as claimed in claim 15, wherein at least one of the at least two submodules is produced by means of the following steps:
a) providing a carrier layer (2) equipped with a conductor path arrangement (4) and at least one passive component (7),
b) providing at least one semiconductor chip (1) on the carrier layer (2),
c) connecting the at least one semiconductor chip (1) to the carrier layer (2),
d) electrically bonding the at least one semiconductor chip (1) to the conductor paths (4),
e) applying and connecting the carrier layer (2) to an intermediate layer comprising at least one opening (6),
f) applying and connecting one cover layer (5), wherein the intermediate layer (3) having the at least one opening (6) is covered, and
g) applying metallizations (9) to ends of the conductor paths (4) situated at the edge area of the carrier layer (2).

## Revendications

1. Composant semi-conducteur extensible par modules, comportant une couche support (2), des couches intermédiaires (3) et des couches de recouvrement (5), le composant semi-conducteur présentant au moins un premier sous-module et le premier sous-module :
- présentant sur les deux faces une couche intermédiaire (3) sur la couche support (2),
- une première face des couches intermédiaires (3) étant reliée à l'une des couches de recouvrement (5), une seconde face des couches intermédiaires (3) étant respectivement reliée à la couche support (2),
- les couches intermédiaires (3) étant pourvues d'au moins une ouverture (6) chacune,
- dans l'ouverture des couches intermédiaires (3), des puces semi-conductrices (1) pouvant être placées,
- au moins une puce semi-conductrice (1) étant placée dans chaque couche intermédiaire (3) et étant reliée moyennant ses plots de contact (14) à un arrangement de pistes conductrices (4) prévu sur chaque face de la couche support (2) et menant à des contacts extérieurs (8) du composant semi-conducteur,
- le matériau de couche intermédiaire et le matériau de couche support étant une feuille d'aluminium en partie pleinement oxydée comportant un noyau métallique en aluminium.

2. Composant semi-conducteur selon la revendication 1, l'arrangement de pistes conductrices (4) se terminant dans une zone située à proximité de la puce semi-conductrice (1) et dans une zone marginale du composant semi-conducteur, et
l'au moins une des couches de recouvrement (5) étant constituée comme dissipateur de chaleur.

3. Composant semi-conducteur selon la revendication 2, **caractérisé en ce que** les extrémités de pistes conductrices (4) situées à proximité de l'au moins une puce semi-conductrice (1) sont situées à l'intérieur d'une ouverture (6).

4. Composant semi-conducteur selon l'une des revendications précédentes, **caractérisé en ce que** l'au moins une couche support (2) présente au moins un composant passif (7).

5. Composant semi-conducteur selon l'une des revendications précédentes, **caractérisé en ce que** l'une des couches de recouvrement (5) dépasse des couches intermédiaires (3) et de la couche support (2) sur au moins une face sur laquelle ne sont pas disposés de contacts extérieurs (8).

6. Composant semi-conducteur selon l'une des revendications précédentes, **caractérisé en ce que** la couche support (2) dépasse des couches intermédiaires (3) et des couches de recouvrement (5) sur la face sur laquelle sont disposés les contacts extérieurs (8).

7. Composant semi-conducteur selon l'une des revendications précédentes, **caractérisé en ce que** toutes les puces semi-conductrices (1) sont alimentées via une piste conductrice (4) commune.

8. Composant semi-conducteur selon l'une des revendications précédentes, **caractérisé en ce que** les contacts extérieurs (8) de la couche support (2) présentent un codage mécanique (17).

9. Composant semi-conducteur selon l'une des revendications précédentes, **caractérisé en ce que** la couche support (2), les couches intermédiaires (3) et au moins l'une des couches de recouvrement (5) présentent des traversées (16).

10. Composant semi-conducteur selon l'une des revendications précédentes, **caractérisé en ce que** les plots de contact porteurs de signal (14) d'au moins deux puces semi-conductrices (1) peuvent être reliés électriquement entre eux moyennant l'arrangement de pistes conductrices (4) et/ou les traversées (16).

11. Composant semi-conducteur selon l'une des revendications précédentes, **caractérisé en ce que**
- un second sous-module comportant une couche support (2), une couche intermédiaire (3) appliquée sur une face de la couche support (2) et à son tour recouverte d'une couche de recouvrement (5), et une puce semi-conductrice placée dans une ouverture de la couche intermédiaire, est prévu,
- le premier sous-module et le second sous-module pouvant être reliés électriquement via des interfaces de contact (13), une interface de contact étant disposée sur l'une des couches de recouvrement (5) du premier sous-module et une interface de contact étant disposée à l'opposé sur la couche support (2) du second sous-module et chaque interface de contact (13) étant reliée électriquement à une traversée (16), laquelle est à son tour reliée de façon électroconductrice à un arrangement de pistes conductrices sur une couche support.

12. Composant semi-conducteur selon l'une des revendications précédentes, **caractérisé en ce que** les extrémités allongées de la couche support (2) présentent des contacts extérieurs (8), et **en ce que** les contacts extérieurs (8) présentent des métallisations (9) sur une face ou sur les deux faces, chacune des deux métallisations (9) portant un signal électrique ou les deux métallisations (9) portant le même signal.

13. Composant semi-conducteur selon l'une des revendications précédentes, **caractérisé en ce que** la couche support (2), les couches intermédiaires (3) et les couches de recouvrement (5) sont reliées au moyen d'adhésif conducteur anisotrope.

14. Procédé de fabrication d'un module multipuce comportant les étapes suivantes :
a) fabrication d'au moins un composant semi-conducteur selon l'une des revendications 1 à 13,
b) fabrication d'au moins un second sous-module, le second sous-module comportant une couche support (2), une couche intermédiaire (3) appliquée sur une face de la couche support (2) et à son tour recouverte d'une couche de recouvrement (5), et une puce semi-conductrice placée dans une ouverture de la couche intermédiaire,
c)
- liaison d'un composant semi-conducteur selon l'une des revendications 1 à 13 via au moins l'une de ses deux couches de recouvrement à la face de la couche support d'un second sous-module qui est opposée à la face équipée de la couche intermédiaire ou
- liaison de deux composants semi-conducteurs selon l'une des revendications 1 à 13 via au moins l'une de leurs deux couches de recouvrement.

15. Procédé de fabrication d'un module multipuce selon la revendication 14, au moins l'un des au moins deux sous-modules à relier étant fabriqué selon les étapes suivantes :
a) prévision d'une couche support (2) équipée d'un arrangement de pistes conductrices (4) et d'au moins un composant passif (7),
b) liaison de la couche support (2) à une couche intermédiaire (3) présentant au moins une ouverture (6),
c) mise en place d'au moins une puce semi-conductrice (1) dans l'au moins une ouverture (6),
d) liaison de l'au moins une puce semi-conductrice (1) avec la couche support (2),
e) mise en contact électrique de l'au moins une puce semi-conductrice (1) avec l'arrangement de pistes conductrices (4),
f) application et liaison d'une couche de recouvrement (5), la couche intermédiaire (3) étant recouverte de l'au moins une ouverture (6), et
g) application de métallisations (9) sur des extrémités des pistes conductrices (4) qui sont situées dans la zone marginale de la couche support (2).

16. Procédé de fabrication d'un module multipuce selon la revendication 15, au moins l'un des au moins deux sous-modules à relier étant fabriqué selon les étapes suivantes :
a) prévision d'une couche support (2) équipée d'un arrangement de pistes conductrices (4) et d'au moins un composant passif (7),
b) prévision d'au moins une puce semi-conductrice (1) sur la couche support (2),
c) liaison de l'au moins une puce semi-conductrice (1) avec la couche support (2),
d) mise en contact électrique de l'au moins une puce semi-conductrice (1) avec les pistes conductrices (4),
e) application et liaison de la couche support (2) avec une couche intermédiaire (3) présentant au moins une ouverture (6),
f) application et liaison d'une couche de recouvrement (5), la couche intermédiaire (3) étant recouverte de l'au moins une ouverture (6), et
g) application de métallisations (9) sur des extrémités des pistes conductrices (4) qui sont situées dans la zone marginale de la couche support (2).
